Europäisches Patentamt

(19) European Patent Office

Office européen des brevets

(11) Numéro de publication: **0 105 010**

**A1**

(12) # DEMANDE DE BREVET EUROPEEN

(21) Numéro de dépôt: **83420150.1**

(22) Date de dépôt: **15.09.83**

(51) Int. Cl.³: **G 01 R 31/28**

(30) Priorité: **17.09.82 FR 8215827**

(43) Date de publication de la demande:
**04.04.84 Bulletin 84/14**

(84) Etats contractants désignés:
**AT BE CH DE GB IT LI LU NL SE**

(71) Demandeur: **GERTY S.A.R.L.**
**13 Chemin du Levant**
**F-01210 Ferney-Voltaire(FR)**

(72) Inventeur: **Yvon, Claude**
**Grande Rue Vanchy**
**F-01200 Bellegarde-sur-Valserine(FR)**

(72) Inventeur: **Gay, Paul**
**12, avenue du Bel Air**
**F-94500 Champigny-sur-Marne(FR)**

(72) Inventeur: **Monloubou, Jacques**
**Immeuble Gendarmerie**
**F-01410 Chezery-Forens(FR)**

(72) Inventeur: **Menot, Claude**
**Les Poncettes Sauverny**
**F-01220 Divonne-les-Bains(FR)**

(74) Mandataire: **Moinas, Michel**
**Cabinet Michel MOINAS 13, Chemin du Levant**
**F-01210 Ferney-Voltaire(FR)**

(54) **Table pour testeur universel de circuits imprimés nus.**

(57) La table pour testeur universel de circuits imprimés nus comprend un support de circuit et deux séries d'aiguilles (13,14) disposées transversalement et se déplaçant longitudinalement sur le circuit (2), parallélement entre elles. Elle comporte également des moyens pour déplacer les deux séries d'aiguilles (13,14), pas à pas et séparément l'une de l'autre, ainsi que des moyens pour les aiguilles (13,14) en contact avec les points de test du circuit.

Un testeur universel utilisant la table comprend, associé à celle-ci, des moyens permettant de commuter deux à deux toutes les aiguilles (13,14) entre elles, et chaque aiguille avec, en bloc, l'ensemble des aiguilles précédentes, les deux séries étant confondues. Il s'agit de mettre en évidence pour chaque test la présence ou l'absence d'une continuité électrique. Le testeur comprend également des moyens de comparaison des signaux avec les signaux d'un circuit imprimé conforme, de façon à détecter les circuits défectueux.

Le déplacement des séries d'aiguilles (13,14), s'effectue en balayant tout le circuit (2), systématiquement ou selon un programme. Dans ce cas, le testeur comprend un calculateur programmable.

./...

EP 0 105 010 A1

Croydon Printing Company Ltd.

Fig 1

# TABLE POUR TESTEUR UNIVERSEL DE
# CIRCUITS IMPRIMES NUS

---

La présente invention se rapporte à une table pour testeur universel de circuits imprimés nus, ainsi qu'à un testeur comprenant la table, le qualificatif "universel" signifiant que le testeur peut s'adapter à divers types de circuits imprimés de divers formats, simples ou multicouches, sans modification de configuration mécanique.

L'industrie électronique a développé des testeurs permettant de contrôler les circuits imprimés nus après fabrication, de manière à s'assurer de leur conformité et à éliminer les circuits défectueux. Il s'agit en pratique de vérifier la bonne continuité des équipotentiels (ou conducteurs électriques du circuit imprimé) en toutes ses extrémités et de vérifier le bon isolement des équipotentiels entre eux. Dans le premier cas on parle de "test de continuité" ; dans le second cas, de "test d'isolement". Ce sont ces deux tests qui doivent être pris en compte.

Pour ce faire on utilise généralement des dispositifs appelés matrices, qui comprennent autant d'aiguilles de contact qu'il y a de points de test possibles sur la surface utile du dispositif. On conprendra aisément que de tels dispositifs sont munis d'un nombre important d'aiguilles et qu'ils doivent être préparés spécialement à la configuration du circuit nu à tester. Avec leurs nombreuses aiguilles, ces dispositifs sont particulièrement onéreux à la fabrication ou à l'achat, et facteur aggravant, il convient d'en posséder un jeu complet adapté à tous les circuits imprimés devant être testés. En outre, changer un tant soit peu la configuration d'un circuit oblige à préparer une nouvelle matrice.

0105010

- 2 -

Au nombre des inconvénients des matrices universelles figurent encore les éléments suivants :

- utilisation très délicate, plusieurs tonnes de presion étant nécessaires pour les aiguilles de contact ou palpeurs,
- nécessité de coupler un multiplexeur possédant autant de points de test que la matrice possède d'aiguilles,
- "universalité" subordonnée à l'emploi de masques adaptés aux circuits à tester,
- maintenance et dépannage du type "fakirien", surtout pour l'accès aux aiguilles du centre.

D'autres dispositifs, du genre "lits de clous personnalisés", sont principalement utilisés pour les tests in-situ. Ils ne peuvent cependant garantir le circuit imprimé que lorsque celui-ci est équipé de ses composants électroniques, ce qui implique :

- la mise au rebut total ou partiel des composants en cas de défauts entraînant le changement du circuit,
- un diagnostic difficile en raison des pannes propres dues aux composants,
- un manque de précision, car il est fréquent de ne trouver qu'une ou deux aiguilles par équipotentiel.

L'invention résoud ces difficultés en proposant d'abord une table pour testeur universel qui comprend un support de circuit et deux séries d'aiguilles disposées transversalement et se déplaçant longitudinalement sur le circuit, parallèlement entre elles. Elle comporte également des moyens pour déplacer les deux séries d'aiguilles, pas à pas et séparément l'une de l'autre, et des moyens pour mettre les aiguilles en contact avec les points de test du circuit.

L'invention a trait ensuite à un testeur universel de circuits imprimés nus, qui comprend la table mentionnée ci-dessus, à laquelle sont associés des moyens permettant de commuter deux à deux toutes les aiguilles entre elles et chaque aiguille avec, en bloc, l'ensemble des aiguilles précédentes, les deux séries étant confondues. Il s'agit de mettre en évidence pour chaque test la présence ou l'absence
d'une continuité électrique. Le testeur comprend enfin des
moyens de comparaison des signaux avec les signaux d'un circuit imprimé conforme, de façon à détecter les circuits défectueux.

Le déplacement des séries d'aiguilles s'effectue, en
balayant tout le circuit selon la séquence suivante :

(1) les deux séries sont contiguës au départ, en correspondance avec les deux premières lignes de tests du circuit,

(2) la série aval, selon le sens du déplacement, balaye
pas par pas le circuit sur toute sa longueur jusqu'à la
dernière ligne de tests,

(3) la série amont se déplace alors d'un pas au moins,

(4) la série aval revient en arrière, jusque, si nécessaire
en position contiguë de la série amont,

(5) la série aval reprend son balayage pas par pas jusqu'au
plus tard la dernière ligne de tests du circuit,

(.) et ainsi de suite,

(n) la fin de l'opération intervenant au plus tard, lorsque
les deux séries sont contiguës, en correspondance avec
les deux dernières lignes de tests du circuit.

Dans une première forme d'exécution, les tests sont
systématiques, tous les pas du circuit et tous les points
de test étant interrogés sans exception. Il s'en suit que,
au départ, les deux séries d'aiguilles sont contiguës en correspondance avec les deux premières lignes de tests du circuit et qu'en fin d'opération ces deux séries sont à nouveau
contiguës, mais en correspondance avec les deux dernières
lignes de tests du circuit.

Dans une deuxième forme d'exécution, préférée, le testeur comprend également un calculateur programmable qui gouverne le déplacement des séries d'aiguilles en faisant sauter des pas, à l'aller comme au retour, de façon à éviter les contacts inutiles ou redondants. On gagne ainsi un temps important sur la durée totale du test ; l'expérience montre en effet qu'au fur et à mesure du déroulement du test, de plus en plus de pas et de points de test sont sautés. L'opération est achevée lorsque la série aval se trouve en correspondance avec la dernière ligne de tests du circuit, la série amont pouvant se trouver en position contiguë, ou en position intermédiaire sur le circuit si les points de test au-delà de cette position intermédiaire sont inutiles ou redondants.

Selon une autre forme d'exécution, un calculateur programmable s'occupe également de la commutation des aiguilles entre elles, de façon à éviter les commutations inutiles ou redondantes. Cette forme d'exécution est particulièrement intéressante lorsque le circuit imprimé a une largeur inférieure aux séries d'aiguilles et qu'une partie de celles-ci, sur un ou deux côtés, doit être systématiquement ignorée.

Avantageusement, les séries d'aiguilles sont portées par des barres et, pour la commodité de l'exposé, la combinaison "barre/aiguilles" sera désignée par "peigne" dans la suite de l'exposé. Les moyens pour déplacer les peignes sont constitués de deux moteurs, de préférence pas à pas, un par peigne.

Les moyens pour mettre les aiguilles en contact avec les points de test des circuits nus comprennent pour chaque peigne un moteur et une came, et les moyens de commutation des aiguilles entre elles peuvent être constitués d'un multiplexeur.

En variante, ces moyens de contact comprennent un seu moteur fixé sur le bâti du dispositif et actionnant une came unique de longueur au moins égale à la course totale des barres. Cette came agit sur des leviers portés par les barres de façon à faire descendre l'ensemble des aiguilles.

Pour comparer les signaux électriques transmis par le circuit en test avec ceux d'un circuit imprimé conforme, en évitant de devoir utiliser un second appareil, on utilise de préférence un calculateur programmable ayant en mémoire les signaux successifs du circuit conforme. La comparaison s'effectue alors avec les informations contenues dans la mémoire.

On "remplit" cette mémoire manuellement, un opérateur se basant sur un circuit imprimé de référence, ou on fait simplement balayer par le testeur un circuit imprimé nu, dont on est sûr qu'il est conforme, et on stocke en mémoire les signaux successifs générés.

En d'autres termes, la mémoire contient la signature d'un circuit imprimé conforme et toute déviation par rapport à cette signature va faire considérer le circuit en test comme défectueux.

De préférence encore, le même calculateur sert à la commande du déplacement des peignes, au multiplexage des aiguilles et à la comparaison des signaux en mémoire.

Dans une première variante, des moyens d'alarme, sonores ou visuels se déclenchent lorsque le circuit testé est défectueux. En variante, ces moyens d'alarme permettent d'identifier les équipotentiels ou le point de test défectueux sur le circuit imprimé nu.

Selon un premier mode de réalisation, le testeur comprend un organe pour l'alimentation, le positionnement et l'évacuation automatique des circuits imprimés. Avantageusement, il comprend également un organe d'éjection automatique des circuits imprimés défectueux.

Selon un deuxième mode de réalisation, le testeur est double et comprend deux unités de tests avec deux organes d'alimentation, de positionnement et d'évacuation, une unité étant en fonction "test" quand l'autre unité est en déplacement.

L'invention est illustrée par le dessin annexé, donné à titre d'exemple, dans lequel :

La figure 1 est une vue de dessus d'une table pour testeur selon l'invention ;

la figure 2 est une vue en bout de la même table pour testeur ;

la figure 3 est une vue de détail de la came qui permet de mettre les aiguilles en contact avec les points de test du circuit;

la figure 4 est une vue de dessous d'un autre testeur selon l'invention;

la figure 5 est une vue de détail de la came et des leviers actionnant les barres.

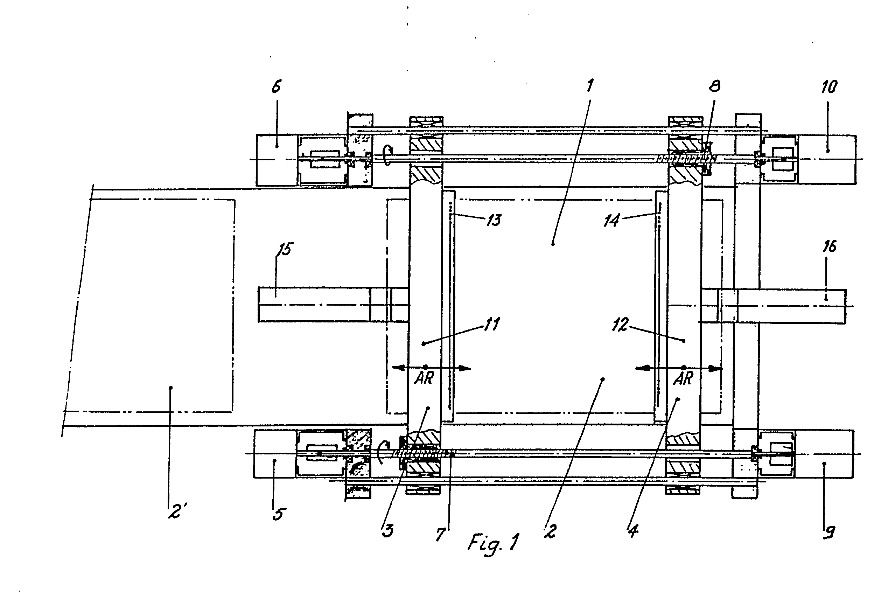

Sur la figure 1, on voit une table coulissante 1 sur laquelle est disposé un circuit imprimé nu en test 2, tandis qu'un autre circuit à tester 2' est en attente.

Au-dessus du circuit sont disposés deux chariots 3 et 4 qui sont animés par des moteurs pas à pas 5 et 6 par l'intermédiaire de vis à billes 7 et 8 respectivement. Ici, ces chariots 3 et 4 sont représentés en positions extrêmes. Deux encodeurs, 9 et 10 respectivement, assurent le contrôle du mouvement des chariots 3 et 4 et permettent un positionnement précis.

Aux chariots 3 et 4 sont fixés des barres 11 et 12 qui portent chacune une série d'aiguilles 13 et 14. Pour la commodité de l'exposé, l'ensemble barre 11/aiguilles 13 sera désigné par peigne amont tandis que l'ensemble barre12/ aiguilles 14 sera désigné par peigne aval.

A chacun des chariots 3,4 est associé respectivement un moteur 15,16 qui actionne des cames non représentées. Les cames prennent appui sur les chariots et permettent d'abaisser les peignes pour mettre les aiguilles en contact avec les points de test du circuit. Les aiguilles sont d'un modèle conventionnel à ressort et l'effort appliqué est de l'ordre de 100 g par aiguille.

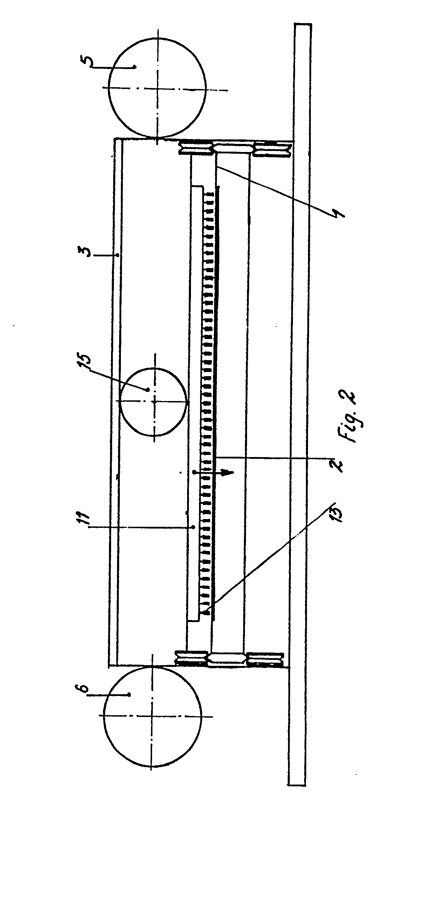

Sur la figure 2, on a choisi la vue en bout côté amont et on retrouve la table coulissante 1 avec un circuit imprimé nu en test 2. On voit le chariot amont 3 actionné par le moteur 5, tandis que le moteur 6 actionne le chariot aval 4 non visible.

Le peigne amont est constitué de la barre 11 porteuse de la série d'aiguilles 13 et le moteur 15 actionne une came non visible qui permet d'abaisser le peigne et de mettre les aiguilles 13 en contact avec les points de tests des circuits. Il existe également, non visible sur la figure, un peigne aval constitué d'une barre 12 et des aiguilles 14, portée par un chariot 4 avec la came correspondante actionnée par son moteur.

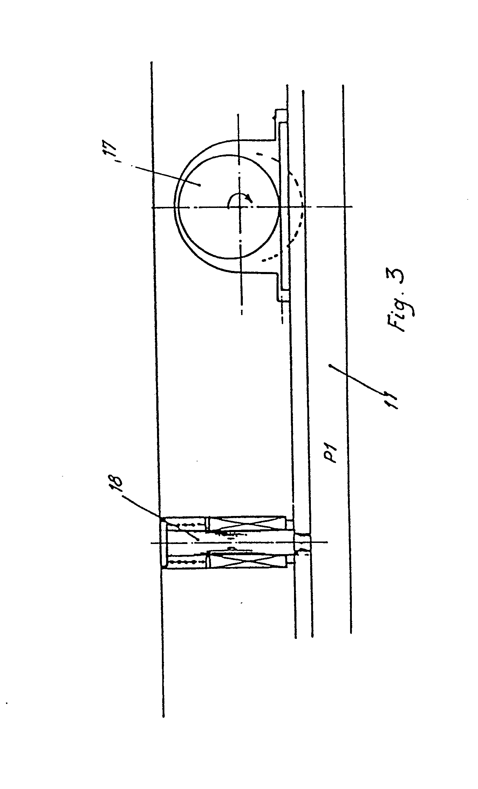

La came amont 17 abaissant la barre 11 est représentée sur la figure 3, la pièce composite 18 étant une colonne de guidage et de rappel. Il existe une came correspondante pour la barre aval.

Les chariots 3 et 4 se déplacent dans un plan horizontal, parallèle au circuit 2 à tester, guidé linéairement par des douilles à billes et arbres de précision. Les moteurs pas à pas 5,6 agissent sur les vis à billes pour l'entraînement des chariots. Des encodeurs 10,11 contrôlent les mouvements des chariots. Ceux-ci peuvent se déplacer vers l'avant comme vers l'arrière selon les doubles flèches AR.

En début de test, les deux chariots sont contigus à gauche de la figure 1 et les peignes 11,12 sont abaissés, selon f, pour que les aiguilles 13,14 soient en contact avec les points de tests du circuit.

Si on fait l'hypothèse de 100 aiguilles par peigne, soit 200 aiguilles en tout numérotées de 1 à 100 sur le peigne amont et de 101 à 200 sur le peigne aval, l'interrogation se fait par commutation selon la séquence suivante :

- test de continuité

    1 avec 2,

    1 avec 3,

    ........

    1 avec 200, puis

    2 avec 3,

    2 avec 4,

    ........

    2 avec 200, puis

    3 avec 4

    ........ et ainsi de suite jusqu'à

    199 avec 200

- test d'isolement

    1 aiguille avec toutes ses précédentes.

De préférence, les tests de continuité et les tests d'isolement sont alternés.

Une fois ces interrogations terminées, les chariots sont soulevés et le peigne aval est déplacé vers l'aval, les aiguilles étant remises en contact avec les points de test du circuit.

Le déplacement du chariot aval est régi par un calculateur programmable de façon à, le cas échéant, sauter des pas pour éviter les redondances. Dans cette variante cependant, les commutations entre aiguilles sont systématiques, sauf à ignorer les aiguilles de côté si le circuit à tester était moins large que les peignes.

On arrive ainsi à une position où le peigne aval est en butée. Alors, le peigne amont est déplacé d'un ou plusieurs pas selon le programme et le peigne aval revient en arrière, toujours selon le programme. Tout repart selon le même processus jusqu'à ce que tous les points de test du circuit aient été interrogés.

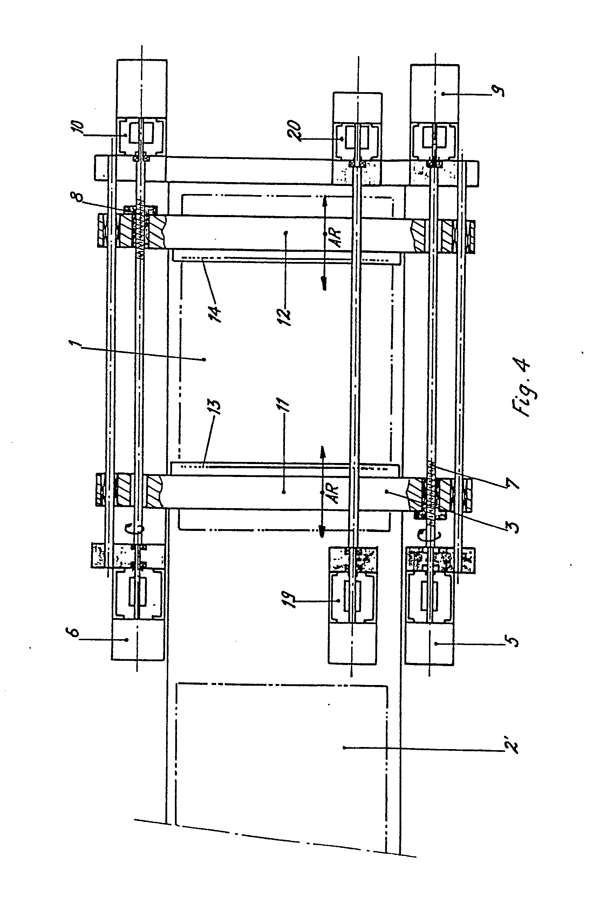

La figure 4, dans laquelle on retrouve les éléments de la figure 1 avec les mêmes références, représente une table 1 munie d'une seule came de longueur au moins égale à la course totale des barres 11,12. Cette came est actionée par un moteur 19, avec son encodeur 20.

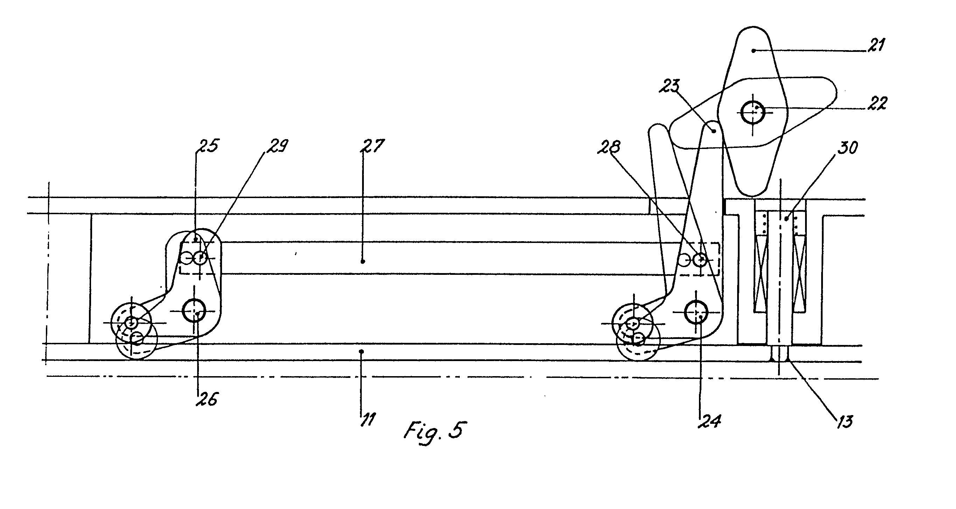

La came 21 comme vue sur la figure 5, est mobile autour d'un axe 22 et prend appui sur un levier 23 mobile autour d'un axe 24. Un autre levier 25, mobile autour d'un axe 26, est solidarisé du levier 23 par une barre 27, les axes de fixation étant figurés en 28 et 29. L'élément porte-aiguilles est représenté en 30.

La came 21, en tournant, repousse les leviers 23 et 25 qui, par basculement autour des axes 24 et 26, abaissent le levier 11 et, par voie de conséquence, les aiguilles 13 qui sont mises en contact avec les points de test du circuit.

Dans une réalisation typique, chaque barre porte 100 aiguilles espacées de 2,54 mm, les pas étant également de 2,54 mm. Il s'agit là des circuits nus standardisés tels qu'on les rencontre le plus fréquemment.

Dans une autre réalisation, les aiguilles sont espacées de 1,27 mm et les pas de 1,27 mm également.

0105010

REVENDICATIONS

-------

1.      Table pour testeur universel de circuits imprimés
nus comportant un support de circuit, caractérisé en
ce qu'elle comprend
   (a) deux séries d'aiguilles (13,14) disposées transversalement et se déplaçant longitudinalement sur
       le circuit (2), parallèlement entre elles,
   (b) des moyens pour déplacer les deux séries d'aiguilles
       (13,14), pas à pas et séparément l'une de l'autre,
   (c) des moyens pour mettre lés aiguilles (13,14) en contact avec les points de test du circuit,

2.      Table selon la revendication, 1 caractérisée en ce
que les séries d'aiguilles (13,14) sont portées par des
barres (11,12) se déplaçant dans un plan parallèle au
circuit (2).

3.      Table selon l'une des revendications 1 et 2, caractérisée en ce que les moyens pour déplacer les deux
séries d'aiguilles (13,14) sont constitués de deux moteurs pas à pas (6,7), un par série d'aiguilles.

4.      Table selon la revendication 2 , caractérisée en
ce que les moyens pour mettre les aiguilles (13,14) en
contact avec les points de test du circuit comprennent
au moins une came.

5.      Table selon l'une des revendications 1 à 4, caractérisée en ce qu'elle comprend un organe pour l'alimentation, le positionnement et l'évacuation automatique
des circuits imprimés.

6.      Table selon la revendication 5, caractérisé en ce
qu'elle comprend un organe d'éjection automatique des
circuits imprimés défectueux.

7.      Utilisation de la table selon l'une des revendications 1 à 6, caractérisée en ce qu'on lui associe

(d) des moyens permettant de commuter deux à deux toutes les aiguilles (13,14) entre elles, et chaque aiguille avec, en bloc, l'ensemble des aiguilles précédentes, les deux séries étant confondues, de façon à mettre en évidence pour chaque test la présence ou l'absence d'une continuité électrique, et

(e) des moyens de comparaison des signaux avec les signaux d'un circuit imprimé conforme, de façon à détecter les circuits défectueux,

le déplacement des séries d'aiguilles (13,14) s'effectuant, en balayant tout le circuit (2), selon la séquence suivante :

(1) les deux séries (13,14) sont contiguës au départ, en correspondance avec les deux premières lignes de tests du circuit (2),

(2) la série aval (14), selon le sens du déplacement, balaye pas par pas le circuit (2) sur toute sa longueur jusqu'à la dernière ligne de tests,

(3) la série amont (13) se déplace alors d'un pas au moins,

(4) la série aval (14) revient en arrière, jusque, si nécessaire, en position contiguë de la série amont (13)

(5) la série aval (14) reprend son balayage pas par pas jusqu'au plus tard la dernière ligne de test du circuit,

(.) et ainsi de suite,

(n) la fin de l'opération intervenant au plus tard, lorsque les deux séries (13,14) sont contiguës, en correspondance avec les deux dernières lignes de tests du circuit.

8.      Utilisation selon la revendication 7, caractérisée en ce que les moyens de commutation des aiguilles (13,14) entre elles sont constitués d'un multiplexeur.

9.      Utilisation selon la revendication 7, caractérisée en ce que toutes les aiguilles (13,14) sont commutées entre elles deux à deux et que tous les pas du circuit imprimé (2) sont balayés, la série (14) revenant en arrière jusqu'en position contiguë avec la série amont (13) et les deux séries (13,14) étant contiguës en fin d'opération, en correspondance avec les deux dernières lignes de tests du circuit.

10.      Utilisation selon la revendication 7, caractérisée en ce que les moyens de comparaison des signaux avec ceux d'un circuit intégré conforme comprennent un calculateur programmable ayant en mémoire les signaux successifs dudit circuit conforme, la comparaison s'effectuant avec les informations contenues dans cette mémoire.

11.      Utilisation selon la revendication 7, caractérisée en ce qu'on associe un calculateur programmable en fonction du circuit à tester lequel gouverne le déplacement des séries d'aiguilles (13,14) en leur faisant sauter des pas, à l'aller comme au retour, de façon à éviter les contacts inutiles ou redondants.

12.      Utilisation selon la revendication 7, caractérisée en ce qu'on associe un calculateur programmable en fonction du circuit à tester, lequel gouverne la commutation de toutes les aiguilles (13,14) deux à deux, ou en bloc, de façon à éviter les commutations inutiles ou redondantes.

13.      Utilisation selon les revendications 10,    et/ou 12, caractérisée en ce que le même calculateur sert à la commande du déplacement des séries d'aiguilles (13, 14), à la commande de la commutation des aiguilles et à la comparaison des signaux.

14. Utilisation selon la revendication 13, caractérisée en ce que la mise en mémoire dans le calculateur des signaux correspondant à un circuit intégré conforme se fait simplement en balayant et lisant un tel circuit conforme.

15. Utilisation selon la revendication 7, caractérisée en ce qu'on associe des moyens d'alarme se déclenchant lorsque le circuit testé est défectueux.

16. Utilisation selon la revendication 15, caractérisée en ce que ces moyens d'alarme identifient le point de test défectueux sur le circuit imprimé.

17. Utilisation selon la revendication 7, caractérisée en ce que la commutation deux-à-deux de toutes les aiguilles (13,14) entre elles d'une part, de chaque aiguille avec en bloc l'ensemble des aiguilles précédentes d'autre part, est alternée.

18. Utilisation selon la revendication 7, caractérisée en ce qu'elle associe deux unités de tests et deux organes d'alimentation, une unité étant en fonction "test" quand l'autre unité est en déplacement sur le circuit imprimé.

Fig. 1

Fig. 2

Fig. 3

Fig. 4

Fig. 5

Office européen des brevets

**RAPPORT DE RECHERCHE EUROPEENNE**

EP 83 42 0150

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | DE-A-2 013 070 (LICENTIA) <br> * en entier * | 1-18 | G 01 R 31/28 |
| X | DE-A-2 800 775 (LUTHER & MAELZER) <br> * en entier * | 1-18 | |

**DOMAINES TECHNIQUES RECHERCHES (Int. Cl. ³)**

G 01 R
H 05 K

Le présent rapport de recherche a été établi pour toutes les revendications

| Lieu de la recherche | Date d'achèvement de la recherche | Examinateur |
|---|---|---|
| LA HAYE | 07-12-1983 | PEETERS S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82